# EUROPEAN PATENT SPECIFICATION

(11) **EP 3 078 062 B1**
(45) Date of publication and mention of the grant of the patent: **25.11.2020**
(21) Application number: 14811955.5
(22) Date of filing: 05.12.2014
(51) Int. Cl.: H01L 31/032, H01L 31/0749, B82Y 30/00, H01L 31/0384, C09D 11/52, B82Y 40/00

(54) **CORE-SHELL NANOPARTICLES FOR PHOTOVOLTAIC ABSORBER FILMS**
KERN-HÜLLE-NANOPARTIKEL FÜR FOTOVOLTAISCHE ABSORBERFOLIEN
NANOPARTICULES À NOYAU/ENVELOPPE POUR FILMS ABSORBANTS PHOTOVOLTAÏQUES

(30) Priority: 06.12.2013 US 201361912916 P
(43) Date of publication of application: 12.10.2016
(73) Proprietor: Nanoco Technologies Ltd, Manchester M13 9NT (GB)
(72) Inventor: NEWMAN, Christoper, West Yorkshire HD9 2LQ (GB)
(74) Representative: Dauncey, Mark Peter
(86) International application number: PCT/GB2014/053628
(87) International publication number: WO 2015/082940

(56) References cited:
- WO-A1-2012/112821
- US-A1- 2007 092 648
- US-A1- 2009 139 574
- HIBBERD C J ET AL: "Non-Vacuum Methods for Formation of Cu(In, Ga) (Se, S)2 Thin Film Photovoltaic Absorbers", PROGRESS IN PHOTOVOLTAICS: RESEARCH AND APPLICATIONS, JOHN WILEY & SONS, LTD, 24 September 2009 (2009-09-24), pages 1-20, XP001090576, ISSN: 1062-7995, DOI: 10.1002/PIP.914 [retrieved on 2009-09-24]
- KUO K T ET AL: "Synthesis and characterization of highly luminescent CuInS"2 and CuInS"2/ZnS (core/shell) nanocrystals", THIN SOLID FILMS, ELSEVIER, AMSTERDAM, NL, vol. 517, no. 3, 1 December 2008 (2008-12-01), pages 1257-1261, XP025712320, ISSN: 0040-6090, DOI: 10.1016/J.TSF.2008.06.023 [retrieved on 2008-06-13]
- Liang Li ET AL: "Highly Luminescent CuInS 2 /ZnS Core/Shell Nanocrystals: Cadmium-Free Quantum Dots for In Vivo Imaging", Chemistry of materials, vol. 21, no. 12, 23 June 2009 (2009-06-23) , pages 2422-2429, XP055040740, ISSN: 0897-4756, DOI: 10.1021/cm900103b

## Description

### BACKGROUND OF THE INVENTION

### 1. Field of the Invention.

The present invention generally relates to semiconductor nanoparticles. More particularly, it relates to methods for preparing core-shell nanoparticles for use in copper indium gallium diselenide/disulfide- (CIGS)-based thin film photovoltaic devices.

### 2. Description of the Related Art.

To gain widespread acceptance, photovoltaic cells ("PV cells," also known as solar cells or PV devices) typically need to produce electricity at a cost that is competitive with that of electricity generated using fossil fuels. Solar cells should preferably have low materials and fabrications costs coupled with increased light-to-electric conversion efficiency. Thin films have intrinsically low materials costs since the amount of material in the thin (∼2-4 µm) active layer is small. Thus, there have been considerable efforts to develop high-efficiency thin-film solar cells. Of the various thin materials studied, chalcopyrite-based devices (Cu(In &/or Ga)(Se &, optionally S)₂, referred to herein generically as "CIGS") have shown great promise and have received considerable interest. Photovoltaic devices based on CIGS materials are efficient because the band gaps of CuInS₂ (1.5 eV) and CuInSe₂ (1.1 eV) are well matched to the solar spectrum.

While CIGS materials are inexpensive, the conventional fabrication methods for CIGS thin films involve costly vapor phase or evaporation techniques. One lower cost solution is to form thin films by depositing particles of CIGS components onto a substrate using solution-phase deposition techniques and then melting or fusing the particles into a thin film. Ideally, the nanoparticles coalesce to form large-grained thin films. The solution-phase deposition may be done using oxide particles of the component metals followed by reduction with H₂ and a reactive sintering with a selenium containing gas (e.g., H₂Se). Alternatively, solution phase deposition may be done using prefabricated CIGS particles.

CIGS-type particles (i.e., CIGS or similar materials) preferably possess certain properties that allow them to form large-grained thin films. For example, the nanoparticles are preferably small and have physical, electronic and optical properties that differ from larger particles of the same material. Such smaller particles typically pack more closely, which promotes the coalescence of the particles upon melting. Also, the nanoparticles preferably have a narrow size distribution. A narrow size distribution promotes a uniform melting temperature, since nanoparticle melting point is directly related to particle size. And uniform melting yields an even and high-quality (good electrical properties) film.

Although solution-phase deposition of CIGS is an inexpensive solution to fabricating thin films, it still has its drawbacks. For example, thin films are typically grown on the back PV cell contact (e.g., a molybdenum electrode). During grain growth gallium particles tend to migrate towards one film side resulting in an uneven gallium distribution. Thus, the final thin film may have a gradient of gallium concentration that increases towards the back PV cell contact and decreases towards the top of the film. An insufficient gallium concentration near the top of the film reduces the ability to obtain a desired voltage through band gap expansion. Another problem with the technique is associated with copper concentration. While a copper-rich environment produces optimal conditions for grain growth, an In+Ga rich environment results in the best electronic performance. One solution to this quandary is to grow large grains with a copper-rich material and then remove the unwanted copper side products by etching the film with a KCN solution. However, this etching technique is both time consuming and inefficient at removing the unwanted copper. Furthermore, KCN is a highly toxic compound. One other drawback is the need to selenize the deposited nanoparticles to achieve an adequate volume expansion for superior grain growth. Volume expansion may be achieved by reacting the relatively small (ionic radius) sulfide with the larger selenide (e.g., react sulfide with selenium atmospheres). This process is harsh and expensive, and it can result in inadvertently selenizing the PV cell contact thereby impeding its electronic performance.

Thus, there is need in the art to improve the solution-phase deposition of CIGS nanoparticles. More particularly, there is a need in the art to prepare CIGS nanoparticles that will grow large grains and form an In+Ga rich thin film. There is also need in the art for CIGS nanoparticles that will prevent gallium migration during grain growth and that do not require harsh selenization processes to achieve volume expansion. Attention is also drawn to the disclosures of WO 2012/112821 A1; US 2009/139574 A1; Kuo et al., Thin Solid Films, 2008, 517, 1257-1261; and Liang et al., Chem. Mater., 2009, 21, 2422-2429. Document WO 2012/112821 A1 discloses a core-shell nanoparticle, wherein the core comprises a metal chalcogenide and the shell comprises metal chalcogenide capping ligands Sn2S6⁴⁻. Document US 2009/139574 A1 recites a process for preparing CIGS-type nanoparticles. Documents Kuo et al. (Thin Solid Films, 2008, 517, 1257-1261) and Liang et al. (Chem. Mater., 2009, 2422-2429) describe highly luminescent CuInS₂/ZnS core/shell nanocrystals.

### BRIEF SUMMARY OF THE INVENTION

The present disclosure generally relates to the preparation of CIGS-type core-shell nanoparticles. In one embodiment, the core-shell nanoparticles include a quaternary or ternary metal chalcogenide core. The core is substantially surrounded by a binary metal chalcogenide shell. In yet another embodiment, a core-shell nanoparticle may be deposited on a PV cell contact (e.g., a molybdenum electrode) via solution-phase deposition. The deposited particles may then be melted or fused into a thin absorber film.

A first aspect of the present invention provides a core-shell nanoparticle comprising: a core, wherein the core comprises a metal chalcogenide having the formula AB₁₋ₓB'ₓC_{2-y}C'_{y} where A is Cu, Zn, Ag or Cd; B and B' are independently Al, In or Ga; C and C' are independently S, Se or Te; 0 ≤ x ≤ 1 ; and 0 ≤ y ≤ 2; and a shell substantially surrounding the core, the shell comprising a binary metal chalcogenide having the formula MₓE_{y}, where M is a metal and E is a chalcogen. The binary metal chalcogenide is selected from the group consisting of CuₓS_{y}, InₓS_{y}, and GaₓS_{y} where 0 < x ≤ 2; and 0 < y ≤ 3.

A second aspect of the present invention provides a plurality of core-shell nanoparticles having one or more cores selected from the group consisting of CuInSe₂; CuInₓGa₁₋ₓSe₂; CuGaSe₂; ZnInSe₂; ZnInₓGa₁₋ₓSe₂; ZnGaSe₂; AgInSe₂; AgInₓGa₁₋ₓSe₂; AgGaSe₂; CuInSe_{2-y}S_{y}; CuInₓGa₁₋ₓSe_{2-y}S_{y}; CuGaSe_{2-y}S_{y}; ZnInSe_{2-y}S_{y}; ZnInₓGa₁₋ₓSe_{2-y}S_{y}; ZnGaSe_{2-y}S_{y}; AgInSe_{2-y}S_{y}; AgInₓGa₁₋ₓSe_{2-y}S_{y}; and AgGaSe_{2-y}S_{y}, where 0 ≤ x ≤ 1 ; and 0 ≤ y ≤ 2.

A third aspect of the present invention provides a core-shell nanoparticle having a core comprising Cu, In, Ga and Se and a shell comprising CuS.

A fourth aspect of the present invention provides a core-shell nanoparticle having a core comprising Cu, In, Ga and Se and a shell comprising InS.

A fifth aspect of the present invention provides a photovoltaic device comprising: a support; a substrate layer on the support; an absorber layer on the substrate layer formed using core-shell nanoparticles according to any of the first to fourth aspects. The photovoltaic device may further comprise a layer comprising cadmium sulfide on top of the absorber layer. The photovoltaic device may further comprise a layer comprising aluminum zinc oxide or indium tin oxide on the cadmium sulfide layer. The photovoltaic device may further comprise a contact layer comprising a metal selected from the group consisting of aluminum, nickel and alloys of nickel and aluminum. In the photovoltaic device the support may be selected from the group consisting of glass, silicon and organic polymers. In the photovoltaic device the stoichiometry may vary with depth within the absorber layer. In the photovoltaic device the In-to-Ga ratio may vary with depth within the absorber layer.

A sixth aspect of the present invention provides a method of forming an absorber layer in a photovoltaic device having a substrate comprising: coating a film of ink onto the substrate, the ink containing CIGS-type core-shell nanoparticles according to any of the first to fourth aspects; annealing the coated substrate at a temperature and for a time sufficient to substantially vaporize organic materials from the film of ink; and, cooling the coated substrate. In the method the coating, annealing and cooling steps may be repeated to from multiple layers within the absorber layer. At least one layer in the absorber layer may have a different stoichiometry than an adjacent layer. In the method the ink may comprise CuS, InS, and GaS shells with CuInGaSe cores to form a matrix of CuInGaSSe with large amounts of CuInGaSe. The method may further comprise heating and exposing the absorber layer to a selenium-containing gas. In the method the ink may have an excess of core-shell nanoparticles with copper- based shells over those with indium-based shells.

### BRIEF DESCRIPTION OF THE SEVERAL VIEWS OF THE DRAWING(S)

The foregoing summary, as well as the following detailed description, will be better understood when read in conjunction with the appended drawings. For the purpose of illustration only, there are shown in the drawings certain embodiments. It should be understood, however, that the inventive concepts disclosed herein are not limited to the precise arrangements and instrumentalities shown in the figures.
Figure 1 is a schematic cross-section of a core-shell nanoparticle, in accordance with an embodiment of the invention.
Figure 2 illustrates layers of a photovoltaic device, in accordance with an embodiment of the invention.
Figure 3 is a flow chart including exemplary steps for forming layers of CIGS materials on a substrate using CIGS-type nanoparticle inks, in accordance with an embodiment of the invention.
Figure 4 illustrates heating and selenizing a core-shell nanoparticle composition to form a CIGS thin film, in accordance with an embodiment of the invention.
Figure 5 is a comparison of UV-Vis and photoluminescence spectra of unshelled CIGS nanoparticles versus CIGS/InS core-shell nanoparticles, in accordance with an embodiment of the invention.
Figure 6 presents an ICP/OES elemental analysis of unshelled CIGS nanoparticles versus CIGS/InS core-shell nanoparticles, in accordance with an embodiment of the invention.
Figure 7 presents an XRD analysis of unshelled CIGS nanoparticles compared to that of core-shell CIGS/InS nanoparticles, in accordance with an embodiment of the invention.

### DETAILED DESCRIPTION OF THE INVENTION

Before explaining at least one embodiment in detail, it should be understood that the inventive concepts set forth herein are not limited in their application to the construction details or component arrangements set forth in the following description or illustrated in the drawings. It should also be understood that the phraseology and terminology employed herein are merely for descriptive purposes and should not be considered limiting.

It should further be understood that any one of the described features may be used separately or in combination with other features. Other invented formulations, methods, features, and advantages will be or become apparent to one with skill in the art upon examining the drawings and the detailed description herein. It is intended that all such additional formulations, methods, features, and advantages be protected by the accompanying claims.

As used herein, "CIGS," "CIS," and "CIGS-type" are used interchangeably and each refer to materials represented by the formula AB₁₋ₓB'ₓC_{2-y}C'_{y}, where A is Cu, Zn, Ag or Cd; B and B' are independently Al, In or Ga; C and C' are independently S, Se or Te; 0 ≤ x ≤ 1; and 0 ≤ y ≤ 2. Example materials include CuInSe₂; CuInₓGa₁₋ₓSe₂; CuGaSe₂; ZnInSe₂; ZnInₓGa₁₋ₓSe₂; ZnGaSe₂; AgInSe₂; AgInₓGa₁₋ₓSe₂; AgGaSe₂; CuInSe_{2-y}S_{y}; CuInₓGa₁₋ₓSe_{2-y}S_{y}; CuGaSe_{2-y}S_{y}; ZnInSe_{2-y}S_{y}; ZnInₓGa₁₋ₓSe_{2-y}S_{y}; ZnGaSe_{2-y} S_{y}; AgInSe_{2-y}S_{y}; AgInₓGa₁₋ₓSe_{2-y}S_{y}; and AgGaSe_{2-y}S_{y}, where 0 ≤ x ≤ 1; and 0 ≤ y ≤ 2.

The present disclosure generally relates to the preparation of CIGS-type core-shell nanoparticles. In the present invention, the core-shell nanoparticles include a quaternary or ternary metal chalcogenide core. The core is substantially surrounded by a binary metal chalcogenide shell. In yet another embodiment, a core-shell nanoparticle may be deposited on a PV cell contact (e.g., a molybdenum electrode) via solution-phase deposition. The deposited particles may then be melted or fused into a thin absorber film.

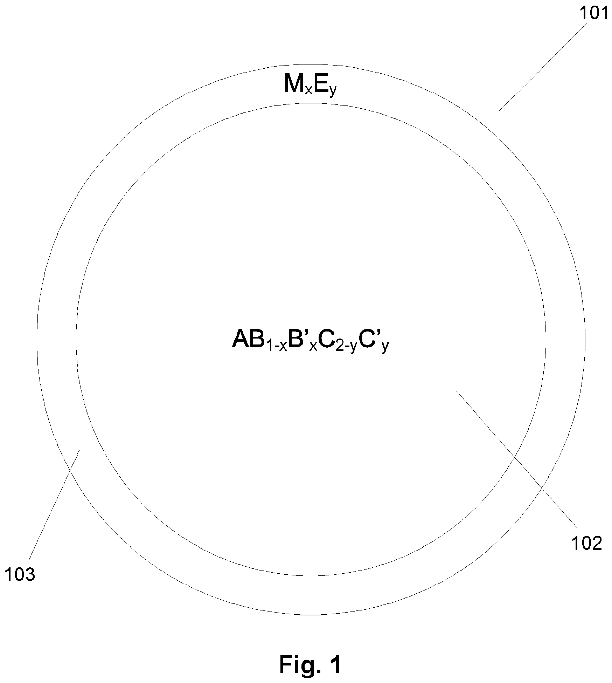

Figure 1, by way of example only, illustrates a cross-section of an embodiment of a core-shell nanoparticle 101. The core-shell nanoparticle includes a core 102. The core 102 includes any metal chalcogenide having the formula AB₁₋ₓB'ₓC_{2-y}C'_{y}, where A is Cu, Zn, Ag or Cd; B and B' are independently Al, In or Ga; C and C' are independently S, Se or Te; 0 ≤ x ≤ 1; and 0 ≤ y ≤ 2. In one embodiment, the nanoparticle core 102 may be a quaternary metal chalcogenide. Without limitation, quaternary metal chalcogenide cores may include CuInₓGa₁₋ₓSe₂; ZnInₓGa₁₋ₓSe₂; AgInₓGa₁₋ₓSe₂; CuInSe_{2-y}S_{y}; CuInₓGa₁₋ₓSe_{2-y}S_{y}; CuGaSe_{2-y}S_{y}; ZnInSe_{2-y}S_{y}; ZnGaSe_{2-y}S_{y}; AgInSe_{2-y}S_{y}; and AgGaSe_{2-y}S_{y}, where 0 ≤ x ≤ 1; and 0 ≤ y ≤ 2. In another embodiment, the quaternary metal chalcogenide core may include Zn instead of Ga, including but not limited to a core having the formula CuInZnS. In another embodiment, the nanoparticle core 102 may be a ternary metal chalcogenide. Without limitation, ternary metal chalcogenide cores may include CuInSe₂, CuGaSe₂, ZnInSe₂, ZnGaSe₂, AgInSe₂, and AgGaSe₂.

The nanoparticle core 102 is substantially surrounded by a metal chalcogenide shell 103. The shell 103 includes a binary metal chalcogenide having the formula MₓE_{y}, where M is any metal and E is any chalcogen. The binary metal chalcogenide is selected from the group consisting of CuₓS_{y}, InₓS_{y}, and GaₓS_{y} where 0 < x ≤ 2; and 0 < y ≤ 3.

In one embodiment the core-shell nanoparticle 101 includes a core 102 made of Cu, In, Ga, and Se (i.e., a "CIGSe" core). The CIGSe core 102 may be substantially surrounded by a shell 103 made of CuS or InS.

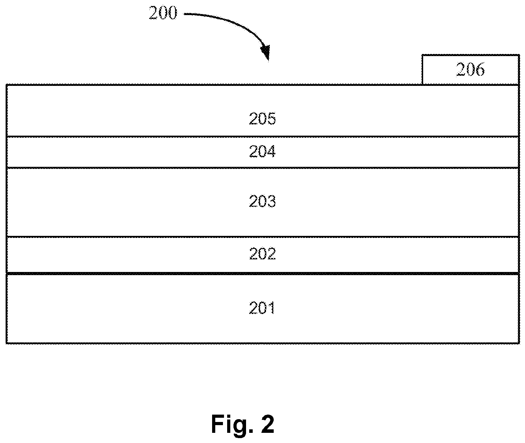

In an embodiment, the aforementioned core-shell nanoparticles may be used to produce a PV cell absorber thin film. Figure 2, by way of example only, illustrates the layers of an exemplary PV device 200 having an absorbing layer derived from core-shell nanoparticles. The exemplary layers are disposed on a support 201. The layers are: a substrate layer 202 (typically molybdenum), an absorbing layer derived from core-shell nanoparticles 203, a cadmium sulfide layer 204, an aluminum zinc oxide layer 205, and an aluminum contact layer 206. One of skill in the art will appreciate that a CIGS-based PV device may include more or fewer layers than are illustrated in Figure 2.

Support 201 may be any type of rigid or semi-rigid material capable of supporting layers 202-206. Examples include glass, silicon, and rollable materials such as plastics. Substrate layer 202 is disposed on support layer 201 to provide electrical contact to the PV device and to promote adhesion of the core-shell nanoparticle-based absorption layer 203 to the support layer.

The absorbing layer 203 is derived from the aforementioned core-shell nanoparticles and may include one or more layers comprising Cu, In and/or Ga, Se and/or S. The core-shell nanoparticle layer may have a uniform stoichiometry throughout the layer. Alternatively, the stoichiometry of the Cu, In and/or Ga, Se and/or S may vary throughout the absorption layer 203. For example, in an embodiment, the absorption layer may include layers having varying gallium content. According to one embodiment, the ratio of In to Ga may vary as a function of depth within the layer. Likewise, the ratio of Se to S may vary within the layer. In still another embodiment, the core-shell nanoparticle-based absorbing layer 203 may be a p-type semiconductor. It may therefore be advantageous to include a layer of n-type semiconductor 204 within PV cell 200. An examples of a suitable n-type semiconductor includes, without limitation, CdS.

Top electrode 205 may be a transparent conductor, such as indium tin oxide (ITO) or aluminum zinc oxide (AZO). Contact with top electrode 205 may be provided by a metal contact 206, which may be essentially any metal, including but not limited to aluminum, nickel, or alloys thereof.

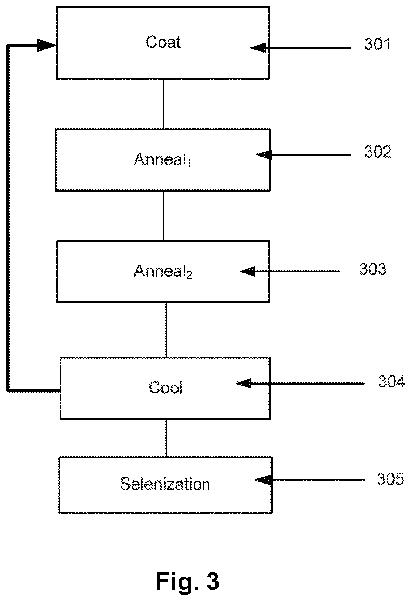

Methods of depositing CIGS layers on a substrate are described in U.S. Patent Application No. 12/324,354, filed November 26, 2008, and published as Pub. No. US2009/0139574 (referred to herein as "the '354 application"). These methods may be used to deposit the core-shell nanoparticles described herein. Briefly, CIGS layers may be formed on a substrate by dispersing CIGS-type core-shell nanoparticles in an ink composition and using the ink composition to form a film on the substrate. The film is then annealed to yield a layer of CIGS material. Figure 3 is a flow chart illustrating exemplary steps for forming layers of CIGS materials on a substrate using CIGS-type core-shell nanoparticle inks. First (301), an ink containing CIGS-type core-shell nanoparticles is used to coat a film onto the substrate using a technique such as printing, spraying, spin-coating, doctor blading, or the like. Exemplary ink compositions are described in the '354 application.

One or more annealing/sintering steps (302, 303) are typically performed following the coating step (301). The annealing step(s) may vaporize organic components of the ink and other organic species, such as capping ligands that may be present on the CIGS-type nanoparticles. The annealing step(s) also melt the CIGS-type nanoparticles. Alternatively or in addition, the deposited ink composition may be melted by reduction with H₂ followed by a reactive sintering with a selenium-containing gas, such as H₂Se (305). Following annealing, the film may be cooled (304) to form the CIGS layer, which preferably is made up of crystals of the CIGS material. The coating, annealing, and cooling steps may be repeated (306) multiple times to form multiple layers in the absorption layer. Each layer may include a different stoichiometry. For example, layers may be formed with different gallium concentrations by varying the gallium concentration in the starting ink composition used for each layer.

In one embodiment, the CIGS materials used in the aforementioned ink composition include one or more of the core-shell nanoparticles described herein with respect to Figure 1. For example, the ink composition may include one or more nanoparticles that include a quaternary or ternary metal chalcogenide core substantially surrounded by a binary metal chalcogenide.

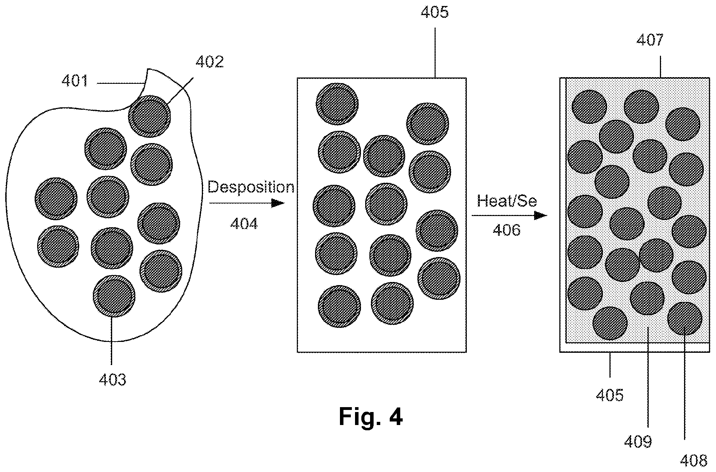

In an embodiment, a CIGS layer is derived from a blend of different types of core-shell nanoparticles. The core-shell nanoparticle cores may behave as isolated/inert to one another during the annealing/sintering process, while the shells act as a reactive material that affects grain growth. Referring to Figure 4, by way of example only, the ink composition 401 may include a blend of CuInGaSe/CuS core-shell nanoparticles 402 with CuInGaSe/InS core-shell nanoparticles 403. The ink composition is deposited 404 on a PV cell contact 405. The deposited nanoparticles are then exposed to heat and a selenium-containing gas 406 to force a reaction between the nanoparticle shells 402, 403. The result is a CIGS layer 407 on top of the PV cell contact 405. In one embodiment, the final thin film layer 407 includes CuInGaSe 408 crystals in a matrix of CuInSSe 409. In an alternative embodiment, the deposited ink composition may include CuS, InS, and GaS shells with CuInGaSe cores to form a matrix of CuInGaSSe with large amounts of CuInGaSe.

The invention disclosed herein provides a number of advantages over conventional solid-phase deposition methods of CIGS nanoparticles. First, the nanoparticle's shell component isolates its core from the surface. Consequently, the shell may prevent gallium from reacting and thus migrating during thin film processing. This may result in a high gallium content, which affects higher band gap material and may lead to increased V_{OC}. Second, the core-shell nanoparticles disclosed herein include a binary metal chalcogenide shell. Binary metal chalcogenides exhibit superior grain growth over quaternary or ternary metal chalcognides. Larger grain growth leads to enhanced current (J_{SC}). In addition, the binary metal chalcogenide is only a small fraction of the core-shell nanoparticle volume. This design avoids grain growth control issues typically observed in forming gallium-containing materials from binary metal chalcogenides. Third, in one embodiment, the ink composition may include an excess of Cu-based shells over In-based shells with an excess of cores loaded with In/Ga. This copper-rich shell environment may maximize grain growth during sintering. On the other hand, the In/Ga cores may ultimately lead to a final film stoichiometry that is copper deficient, thereby meeting optimum electronic requirements. Fourth, in another embodiment, the core-shell nanoparticle cores may include selenium in lieu of sulfur. This means that there is no need to replace sulfur in the majority of the thin film for volume expansion. It is contemplated that, if the outer part of each particle is made up using S as the anion, the sulfur can be replaced by selenium, providing volume expansion where the reaction is most accessible and where the expansion will be of most benefit (at the surfaces where gap filling and grain boundary fusion are desired). Inasmuch as the core is composed using Se as the anion, there is no need for the reactive gas to penetrate deep into the particle to replace further S to achieve homogeneity and maintain the desired bandgap. This may allow a lower concentration of the Se reagent and/or shorter processing time and/or possibly lower processing temperature. Therefore, a less-harsh selenization process may be implemented, such as a lower concentration of H₂Se or elemental selenium.

### Examples

### Example 1: Synthesis of a Core-shell Nanoparticle

This example describes one method for synthesizing a ClGSe/InS core-shell nanoparticle. However, the same or similar method may be used to make any other core-shell nanoparticles described in accordance with the embodiments herein by simply substituting starting materials at appropriate ratios. For example, the core starting material CIGSe could be substituted with any metal chalcogenide having the formula AB₁₋ₓB'ₓC_{2-y}C'_{y}, where A is Cu, Zn, Ag or Cd; B and B' are independently Al, In or Ga; C and C' are independently S, Se or Te; 0 ≤ x ≤ 1; and 0 ≤ y ≤ 2. In addition, the shell starting material, indium(III)diethyldithiocarbamate, could be substituted with any chalcogenide having the formula MₓE_{y} and selected from the group consisting of CuₓS_{y}, InₓS_{y}, and GaₓS_{y}, where 0 < x ≤ 2 and 0 < y ≤ 3.

In one embodiment, an oven-dried 250ml round bottom flask was charged with 2.68g of CIGSe core nanoparticles and subsequently fitted with a Liebig condenser. The flask was thoroughly purged with N2. 30ml of degassed dibenzylether were added to the flask and the mixture was heated to 150°C. A vial under N2 was also charged with 0.978g of indium(III)diethyldithiocarbamate, 14ml of degassed dibenzylether, and 6ml of trioctylphosphine. The resulting vial suspension was then added to the CIGSe solution, and the mixture was heated to 200°C for 90 minutes. Finally, the mixture was allowed to cool to room temperature.

After cooling, the flask was opened to the atmosphere and the mixture was spun at 2700G for five minutes. The supernatant was set aside and the remaining solid was dispersed in 25ml of toluene. This dispersion was spun at 2700G for five minutes and the supernatant was then combined with the dispersion. Any remaining solids were further dispersed in 15ml of toluene and the mixture was spun at 2700G for five minutes. The supernatant was again combined with the dispersion and any remaining residue was discarded. 250ml of methanol were added to the combined supernatants and the mixture was spun at 2700G for five minutes. The colorless supernatant was discarded and the resulting solid was re-precipitated from 25ml dichloromethane/200ml methanol. The precipitate was isolated by centrifugation and dried under vacuum (yield: 2.218g).

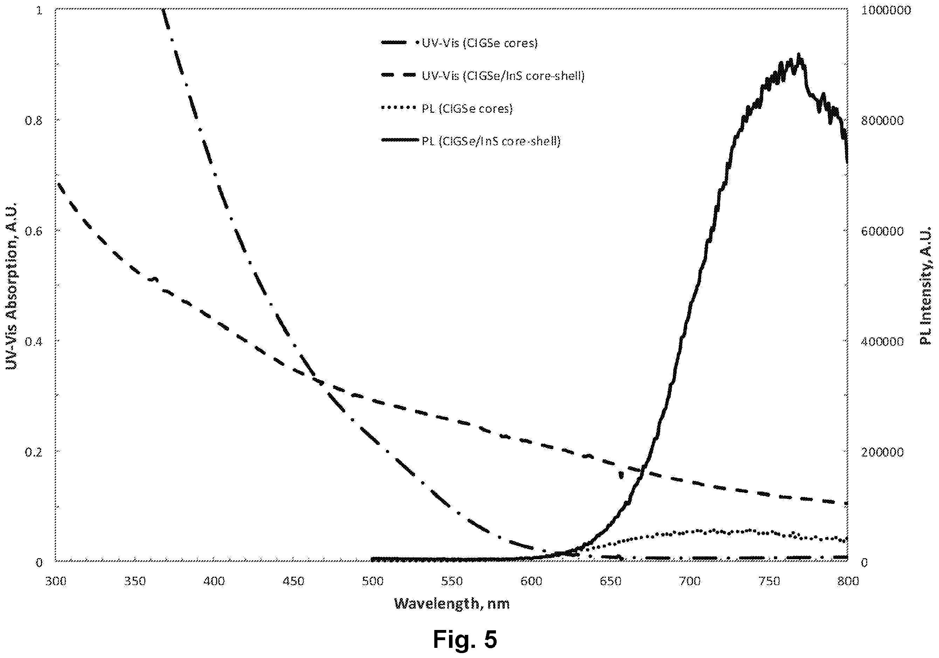

Figure 5, by way of example only, compares the UV-Vis and photoluminescence spectra of unshelled CIGSe nanoparticles with those of ClGSe/InS core-shell nanoparticles. In an embodiment, there is an increase in peak intensity when the CIGSe material reacts with the indium(III)diethyldithiocarbamate to form the InS shell. This is an expected outcome when a higher bandgap material is used as a shell to passivate the core nanoparticle surface. It also indicates shell formation as opposed to either separate nanoparticle formation or doping of the In and S into the existing CIGSe nanoparticles.

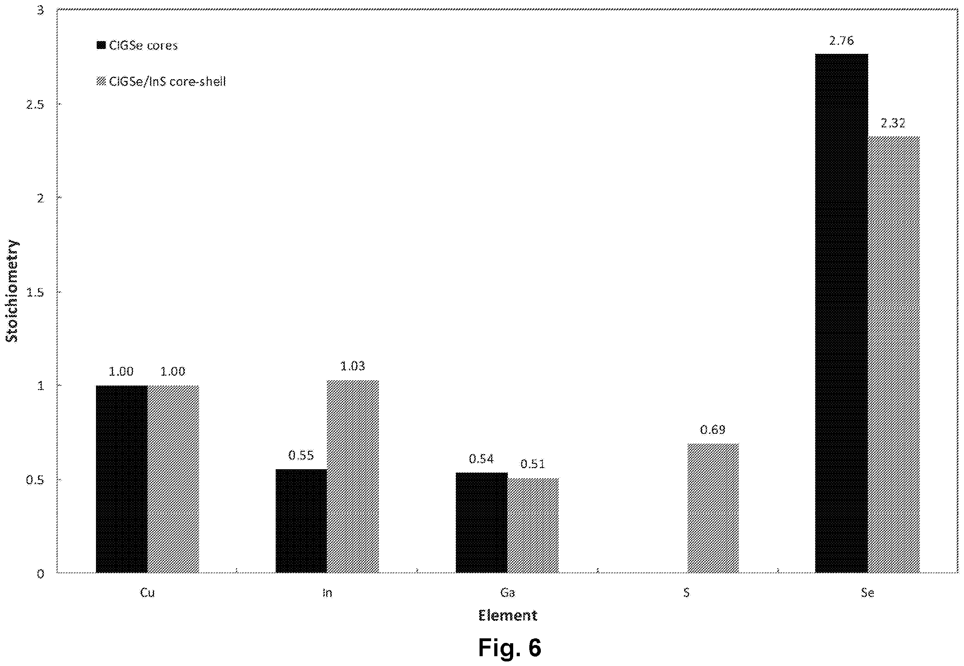

Figure 6, by way of example only, presents a comparison of an ICP/OES elemental analysis of unshelled CIGSe nanoparticles with those of ClGSe/InS core-shell nanoparticles. In an embodiment, results show an increase in In and S content in the core-shell nanoparticles.

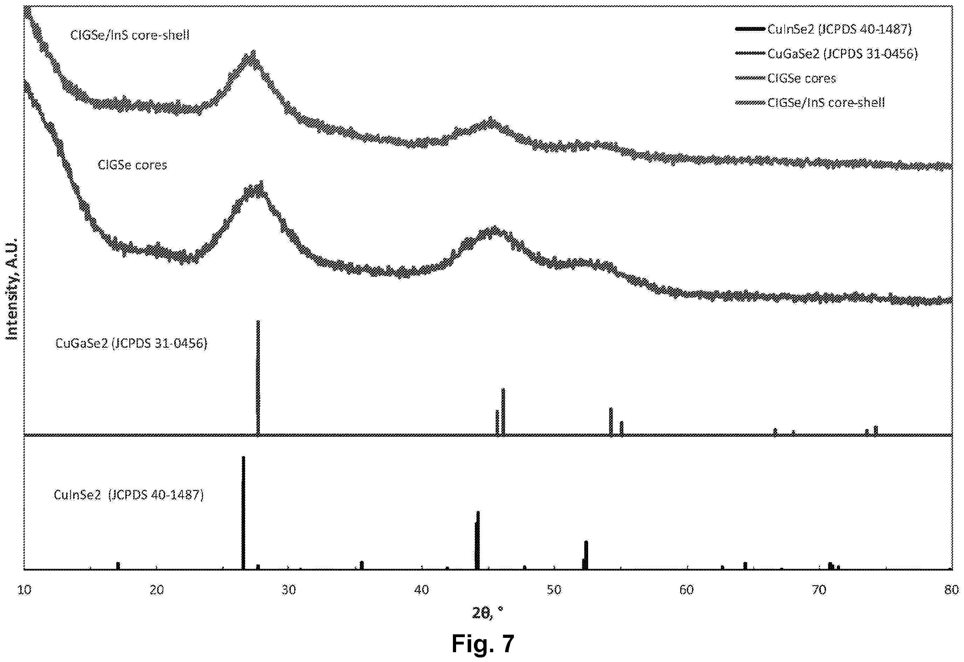

Figure 7, by way of example only, presents a comparison of an XRD analysis of unshelled CIGS nanoparticles versus that of core-shell CIGS/InS nanoparticles, and reference patterns for CIS and CGS nanoparticles from the database of the Joint Committee on Powder Diffraction Standards (JCPDS). In an embodiment, results show that no extra peaks from other phases or materials develop upon shell formation, indicating the presence of shells as opposed to doping or separate nucleation.

The foregoing presents particular embodiments of a system embodying the principles of the invention. Those skilled in the art will be able to devise alternatives and variations which, even if not explicitly disclosed herein, embody those principles and are thus within the scope of the invention. Although particular embodiments of the present invention have been shown and described, they are not intended to limit what this patent covers. One skilled in the art will understand that various changes and modifications may be made without departing from the scope of the present invention as defined by the following claims.

## Claims

1. A core-shell nanoparticle (101) comprising:
a core (102), wherein the core comprises a metal chalcogenide having the formula AB₁₋ₓB'ₓC_{2-y}C'_{y}
where A is Cu, Zn, Ag or Cd; B is Al, In or Ga; B' is Al, In or Ga; B ≠ B'; C is S, Se or Te; C' is S, Se or Te; C ≠ C'; 0 ≤ x ≤ 1; and 0 ≤ y ≤ 2; and
a binary metal chalcogenide shell (103) substantially surrounding the core, the binary metal chalcogenide shell having the formula MₓE_{y}, where M is a metal and E is a chalcogen,
**characterised in that** the binary metal chalcogenide is selected from the group consisting of CuₓS_{y}, InₓS_{y}, and GaₓS_{y}, where 0 < x ≤ 2 and 0 < y ≤ 3.

2. A plurality of core-shell nanoparticles according to claim 1, wherein the core comprises a metal chalcogenide selected from the group consisting of CuInSe₂; CuInₓGa₁₋ₓSe₂; CuGaSe₂; ZnInSe₂; ZnInₓGa₁₋ₓSe₂; ZnGaSe₂; AgInSe₂; AgInₓGa₁₋ₓSe₂; AgGaSe₂; CuInSe_{2-y}S_{y}; CuInₓGa₁₋ₓSe_{2-y}S_{y}; CuGaSe_{2-y}S_{y}; ZnInSe_{2-y}S_{y}; ZnInₓGa₁₋ₓSe_{2-y}S_{y}; ZnGaSe_{2-y}S_{y}; AgInSe_{2-y}S_{y}; AgInₓGa₁₋ₓSe_{2-y}S_{y}; and AgGaSe_{2-y}S_{y}, where 0 ≤ x ≤ 1; and 0 ≤ y ≤ 2.

3. A core-shell nanoparticle according to claim 1 wherein the core comprises Cu, In, Ga and Se and the binary metal chalcogenide shell is CuS.

4. A core-shell nanoparticle according to claim 1 wherein the core comprises Cu, In, Ga and Se and the binary metal chalcogenide shell is InS.

5. A photovoltaic device (200) comprising:
a support (201);
a substrate layer (202) on the support;
an absorber layer (203) on the substrate layer formed using core-shell nanoparticles according to any one of claims 1-4.

6. The photovoltaic device recited in claim 5 further comprising a layer (204) comprising cadmium sulfide on top of the absorber layer.

7. The photovoltaic device recited in claim 6 further comprising a layer comprising:
(i) aluminum zinc oxide (205) on the cadmium sulfide layer; or
(ii) indium tin oxide (205) on the cadmium sulfide layer, optionally wherein the photovoltaic device further comprises a contact layer (206) comprising a metal selected from the group consisting of aluminum, nickel and alloys of nickel and aluminum.

8. The photovoltaic device recited in claim 5 wherein the support is selected from the group consisting of glass, silicon and organic polymers.

9. The photovoltaic device recited in claim 5 wherein:
(i) the stoichiometry varies with depth within the absorber layer; or
(ii) the In-to-Ga ratio varies with depth within the absorber layer.

10. A method of forming an absorber layer (203) n a photovoltaic device (200) having a substrate (201) comprising:
coating a film of ink (401) onto the substrate, the ink containing CIGS-type core-shell nanoparticles (402) according to any one of claims 1-4;
annealing the coated substrate at a temperature and for a time sufficient to substantially vaporize organic materials from the film of ink; and,
cooling the coated substrate.

11. The method recited in claim 10 wherein the coating, annealing and cooling steps are repeated to from multiple layers within the absorber layer, optionally wherein at least one layer in the absorber layer has a different stoichiometry than an adjacent layer.

12. The method recited in claim 10 wherein the ink:
(i) comprises CuS, InS, and GaS shells with CuInGaSe cores to form a matrix of CuInGaSSe with large amounts of CuInGaSe; or
(ii) has an excess of core-shell nanoparticles with copper-based shells over those with indium-based shells.

13. The method recited in claim 10 further comprising heating and exposing the absorber layer to a selenium-containing gas.

## Patentansprüche

1. Kern-Hülle-Nanopartikel (101), umfassend:
einen Kern (102), wobei der Kern Metallchalkogenid umfasst mit der Formel AB₁₋ₓB'ₓC_{2-y}C'_{y}
wobei A Cu, Zn, Ag oder Cd ist; B Al, In oder Ga ist; B' Al, In oder Ga ist, B ≠ B'; C S, Se oder Te ist; C' S, Se oder Te ist, C ≠ C'; 0 ≤ x ≤ 1; und 0 ≤ y ≤ 2; und
eine binäre Metallchalkogenidhülle (103), die den Kern im Wesentlichen umgibt, wobei die binäre Metallchalkogenidhülle die Formel MₓE_{y} aufweist, wobei M ein Metall ist und E ein Chalkogen ist,
**dadurch gekennzeichnet, dass** das binäre Metallchalkogenid aus der Gruppe ausgewählt ist, bestehend aus CuₓS_{y}, InₓS_{y} und GAₓS_{y}, wobei 0 < x ≤ 2 und 0 < y ≤ 3.

2. Vielzahl von Kern-Hülle-Nanopartikeln nach Anspruch 1, wobei der Kern ein Metallchalkogenid umfasst, ausgewählt aus der Gruppe, bestehend aus CuInSe₂; CuInₓGa₁₋ₓSe₂; CuGaSe₂; ZnInSe₂; ZnInₓGa₁₋ₓSe₂; ZnGaSe₂; AgInSe₂; AgInₓGa₁₋ₓSe₂; AgGaSe₂; CuInSe_{2-y}S_{y}; CuInₓGa₁₋ₓSe_{2-y}S_{y}; CuGaSe_{2-y}S_{y}; ZnInSe_{2-y}S_{y}; ZnInₓGa₁₋ₓSe_{2-y}S_{y}; ZnGaSe_{2-y}S_{y}; AgInSe_{2-y}S_{y}; AgInₓGa₁₋ₓSe_{2-y}S_{y}; und AgGaSe_{2-y}S_{y}, mit 0 ≤ x ≤ 1 und 0 ≤ y ≤ 2.

3. Kern-Hülle-Nanopartikel nach Anspruch 1, wobei der Kern Cu, In, Ga und Se umfasst und die binäre Metallchalkogenidhülle CuS ist.

4. Kern-Hülle-Nanopartikel nach Anspruch 1, wobei der Kern Cu, In, Ga und Se umfasst und die binäre Metallchalkogenidhülle InS ist.

5. Fotovoltaische Vorrichtung (200), umfassend:
eine Unterstützung (201);
eine Substratschicht (202) auf der Unterstützung;
eine Absorberschicht (203) auf der Substratschicht, gebildet unter Verwendung von Kern-Hülle-Nanopartikeln nach einem der Ansprüche 1-4.

6. Fotovoltaische Vorrichtung nach Anspruch 5, ferner umfassend eine Schicht (204), umfassend Cadmiumsulfid oben auf der Absorberschicht.

7. Fotovoltaische Vorrichtung nach Anspruch 6, ferner umfassend eine Schicht, umfassend:
(i) Aluminiumzinkoxid (205) auf der Cadmiumsulfidschicht; oder
(ii) Indiumzinnoxid (205) auf der Cadmiumsulfidschicht, wobei wahlweise die fotovoltaische Vorrichtung ferner eine Kontaktschicht (206) umfasst, umfassend ein Metall, ausgewählt aus der Gruppe, bestehend aus Aluminium, Nickel und Legierungen von Nickel und Aluminium.

8. Fotovoltaische Vorrichtung nach Anspruch 5, wobei die Unterstützung aus der Gruppe ausgewählt ist, bestehend aus Glas, Silicium und organischen Polymeren.

9. Fotovoltaische Vorrichtung nach Anspruch 5, wobei:
(i) die Stöchiometrie mit der Tiefe innerhalb der Absorberschicht variiert; oder
(ii) das Verhältnis von In zu Ga mit der Tiefe innerhalb der Absorberschicht variiert.

10. Verfahren zum Bilden einer Absorberschicht (203) in einer fotovoltaischen Vorrichtung (200) mit einem Substrat (201), umfassend:
Beschichten eines Films von Tinte (401) auf das Substrat, wobei die Tinte Kern-Hülle-Nanopartikel des CIGS-Typs (402) nach einem der Ansprüche 1-4 enthält;
Tempern des beschichteten Substrats bei einer Temperatur und für eine Zeit, die ausreichend sind, organische Materialien aus dem Tintenfilm im Wesentlichen zu verdampfen; und
Abkühlen des beschichteten Substrats.

11. Verfahren nach Anspruch 10, wobei die Schritte des Beschichtens, Temperns und Abkühlens wiederholt werden, um mehrere Schichten innerhalb der Absorberschicht zu bilden, wobei wahlweise mindestens eine Schicht in der Absorberschicht eine andere Stöchiometrie als eine angrenzende Schicht aufweist.

12. Verfahren nach Anspruch 10, wobei die Tinte:
(i) CuS-, InS- und GaS-Hüllen mit CuInGaSe-Kernen umfasst, um eine Matrix von CuInGaSSe mit großen Mengen von CuInGaSe zu bilden; oder
(ii) einen Überschuss von Kern-Hülle-Nanopartikeln mit kupferbasierten Hüllen über denjenigen mit indiumbasierten Hüllen aufweist.

13. Verfahren nach Anspruch 10, ferner umfassend, die Absorberschicht zu erwärmen und einem Gas, das Selen enthält, auszusetzen.

## Revendications

1. Nanoparticule à noyau-enveloppe (101) comprenant :
un noyau (102), dans laquelle le noyau comprend un chalcogénure métallique qui présente la formule AB₁₋ₓB'ₓC_{2-y}C'_{y}
dans laquelle A est Cu, Zn, Ag ou Cd ; B est Al, In ou Ga ; B' est Al, In ou Ga ; B ≠ B' ; C est S, Se ou Te ; C' est S, Se ou Te ; C ≠ C' ; 0 ≤ x ≤ 1 ; et 0 ≤ y ≤ 2 ; et
une enveloppe en chalcogénure métallique binaire (103) qui entoure sensiblement le noyau, l'enveloppe en chalcogénure métallique binaire présentant la formule MₓE_{y}, dans laquelle M est un métal et E est un chalcogène ;
**caractérisée en ce que** le chalcogénure métallique binaire est sélectionné parmi le groupe constitué de CuₓS_{y}, InₓS_{y} et GaₓS_{y} dans lequel 0 < x ≤ 2 et 0 < y ≤ 3.

2. Pluralité de nanoparticules à noyau-enveloppe selon la revendication 1, dans laquelle le noyau comprend un chalcogénure métallique qui est sélectionné parmi le groupe constitué de CuInSe₂ ; CuInₓGa₁₋ₓSe₂ ; CuGaSe₂ ; ZnInSe₂ ; ZnInₓGa₁₋ₓSe₂ ; ZnGaSe₂ ; AgInSe₂ ; AgInₓGa₁₋ₓSe₂ ; AgGaSe₂ ; CuInSe_{2-y}S_{y} ; CuInₓGa₁₋ₓSe_{2-y}S_{y} ; CuGaSe_{2-y}S_{y} ; ZnInSe_{2-y}S_{y} ; ZnInₓGa₁₋ₓSe_{2-y}S_{y} ; ZnGaSe_{2-y}S_{y} ; AgInSe_{2-y}S_{y} ; AgInₓGa₁₋ₓSe_{2-y}S_{y} ; et AgGaSe_{2-y}S_{y}, dans lequel 0 ≤ x ≤ 1 ; et 0 ≤ y ≤ 2.

3. Nanoparticule à noyau-enveloppe selon la revendication 1, dans laquelle le noyau comprend du Cu, de l'In, du Ga et du Se et l'enveloppe en chalcogénure métallique binaire est du CuS.

4. Nanoparticule à noyau-enveloppe selon la revendication 1, dans laquelle le noyau comprend du Cu, de l'In, du Ga et du Se et l'enveloppe en chalcogénure métallique binaire est de l'InS.

5. Dispositif photovoltaïque (200) comprenant :
un support (201) ;
une couche de substrat (202) sur le support ;
une couche absorbeuse (203) sur la couche de substrat qui est formée en utilisant des nanoparticules à noyau-enveloppe selon l'une quelconque des revendications 1-4.

6. Dispositif photovoltaïque tel que revendiqué selon la revendication 5, comprenant en outre une couche (204) qui comprend du sulfure de cadmium au-dessus de la couche absorbeuse.

7. Dispositif photovoltaïque tel que revendiqué selon la revendication 6, comprenant en outre une couche qui comprend :
(i) de l'oxyde d'aluminium et de zinc (205) sur la couche en sulfure de cadmium ; ou
(ii) de l'oxyde d'indium et d'étain (205) sur la couche en sulfure de cadmium, optionnellement dans lequel le dispositif photovoltaïque comprend en outre une couche de contact (206) qui comprend un métal qui est sélectionné parmi le groupe constitué de l'aluminium, le nickel et les alliages de nickel et d'aluminium.

8. Dispositif photovoltaïque selon la revendication 5, dans lequel le support est sélectionné parmi le groupe constitué de verre, silicium et de polymères organiques.

9. Dispositif photovoltaïque selon la revendication 5, dans lequel :
(i) la stœchiométrie varie en fonction de la profondeur à l'intérieur de la couche absorbeuse ; ou
(ii) le rapport In sur Ga varie en fonction de la profondeur à l'intérieur de la couche absorbeuse.

10. Procédé de formation d'une couche absorbeuse (203) dans un dispositif photovoltaïque (200) qui comporte un substrat (201), comprenant :
le dépôt par revêtement d'un film d'encre (401) sur le substrat, l'encre contenant des nanoparticules à noyau-enveloppe du type CIGS contenant de l'encre (402) selon l'une quelconque des revendications 1-4 ;
le recuit du substrat revêtu à une température et pendant un temps qui suffisent pour vaporiser sensiblement les matières organiques issues du film d'encre ; et
le refroidissement du substrat revêtu.

11. Procédé tel que revendiqué selon la revendication 10, dans lequel les étapes de dépôt par revêtement, de recuit et de refroidissement sont répétées de manière à former de multiples couches à l'intérieur de la couche absorbeuse, optionnellement dans lequel au moins une couche dans la couche absorbeuse présente une stœchiométrie qui est différente de celle d'une couche adjacente.

12. Procédé tel que revendiqué selon la revendication 10, dans lequel l'encre :
(i) comprend des enveloppes en CuS, InS et GaS avec des noyaux en CuInGaSe pour former une matrice en CuInGaSSe avec des quantités importantes de CuInGaSe ; ou
(ii) comporte une surabondance de nanoparticules à noyau-enveloppe avec des enveloppes à base de cuivre au-dessus de celles avec des enveloppes à base d'indium.

13. Procédé tel que revendiqué selon la revendication 10, comprenant en outre le chauffage et l'exposition de la couche absorbeuse à un gaz contenant du sélénium.
